# EUROPÄISCHE PATENTANMELDUNG

(11) **EP 4 576 952 A1**
(43) Veröffentlichungstag der Anmeldung: **25.06.2025**
(21) Anmeldenummer: 23219354.0
(22) Anmeldetag: 21.12.2023
(51) Int. Cl.: H05K 5/02, H05K 5/06, H05K 7/14

(54) **AUTOMATISIERUNGSKOMPONENTE**

(71) Anmelder: Siemens Aktiengesellschaft, 80333 München (DE)
(72) Erfinder: Görlich, Stefan, 92278 Illschwang (DE); Hubmann, Stefan, 92237 Sulzbach-Rosenberg (DE)
(74) Vertreter: Siemens Patent Attorneys

(57) **Zusammenfassung**

Um den Hygieneanforderungen gerecht zu werden wird eine Automatisierungskomponente (10) für die industrielle Automatisierung bereitgestellt, wobei Füße (11,12) zum Befestigen auf der Montagefläche (4) einen Befestigungsbereich (11a,12a) aufweisen, dazu ist eine Kontaktfläche (11b,12b) innerhalb des Befestigungsbereiches (11a,12a) angeordnet, wobei ein Loch (L) der Befestigungsöffnung (21) wiederum innerhalb der Kontaktfläche (11b,12b) angeordnet ist, die Kontaktfläche (11b,12b) ist derart ausgestaltet, dass sie aus dem Befestigungsbereich (11a,12a) herausragt und dadurch eine die Kontaktfläche (11b,12b) ringförmig umschließende Aussparung (A) gebildet ist, die Aussparung (A) ist damit zwischen der herausragenden Kontaktfläche (11b,12b) und einem äußerem Randbereich (RB) des Befestigungsbereiches (11a,12a) angeordnet, der äußere Randbereich (RB) ist als ein umlaufender Kragen (K) um die Aussparung (A) ausgestaltet, wobei der Kragen (K) tiefer angeordnet ist als die herausragende Kontaktfläche (11b) und eine zur Montagefläche (4) gerichtete Kragenfläche (KF) aufweist, ein ringförmiges Dichtelement (D) aufweisend eine Dichtlippe (DL), eine erste Auflagefläche (A1) und eine zweite Auflagefläche (A2), ist derart ausgestaltet, dass die Dichtlippe (DL) in der Aussparung (A), die erste Auflagefläche (A1) auf der Kragenfläche (KF) und die zweite Auflagefläche (A2) zur Montagefläche (4) angeordnet ist, wobei das Dichtelement (D) die herausragende Kontaktfläche (11b) ringförmig umschließt.

## Beschreibung

Die Erfindung betrifft eine Automatisierungskomponente für die industrielle Automatisierung aufweisend ein Gehäuse umfassend ein Oberteil und ein Unterteil, wobei das Oberteil und das Unterteil derart ausgestaltet sind, dass zum Befestigen der Automatisierungskomponente an einer Montagefläche das Gehäuse eine erste Befestigungsöffnung und eine zweite Befestigungsöffnung aufweist.

Beispielsweise bei einem Einsatz von Automatisierungsgeräten in medizinischen Bereichen oder in der Nahrungs- und Genussmittelindustrie bestehen an die dort eingesetzten Geräte besondere Anforderungen hinsichtlich der hygienischen Bedingungen. Diese Anforderungen beziehen sich im Wesentlichen auf die Reinigbarkeit der eingesetzten Geräte.

Nach dem Stand der Technik sind folgende Automatisierungs-Geräte bzw. Komponenten bekannt:
Balluff Network Interface IO-Link BNI IOL-252-000-Z013 gemäß Montageanleitung.
Digital Module AXL E IOL DI16 M12 6P gemäß https://www.phoenixcontact.com/us/products/2702660.
SIMATIC ET 200AL, DI 8x 24 V DC, 8XM8, Degree of protection IP67 gemäß Datenblatt vom 21.05.2020 bzw. gemäß Gerätehandbuch A5E32349561-AD von 08/2021.

All diese bekannten Automatisierungskomponenten haben den Nachteil, dass sie mit ihren Befestigungsöffnung flach auf eine Montagefläche anschraubbar konstruiert sind und damit eine umlaufende Schmutzsammelkante entsteht.

Es ist eine Aufgabe der Erfindung eine Automatisierungskomponente bereitzustellen, welche den Anforderungen der Lebensmittelindustrie bezüglich der Hygiene gerecht wird.

Die Aufgabe wird dadurch gelöst, dass das Unterteil einen ersten Fuß und einen zweiten Fuß aufweist, wobei die Füße einstückig mit dem Unterteil ausgebildet sind und die erste Befestigungsöffnung durch den ersten Fuß und die zweite Befestigungsöffnung durch den zweiten Fuß verläuft, die Füße weisen zum Befestigen auf der Montagefläche einen Befestigungsbereich auf, dazu ist eine Kontaktfläche innerhalb des Befestigungsbereiches angeordnet, wobei ein Loch der Befestigungsöffnung wiederum innerhalb der Kontaktfläche angeordnet ist, die Kontaktfläche ist derart ausgestaltet, das sie aus dem Befestigungsbereich herausragt und dadurch eine die Kontaktfläche ringförmig umschließende Aussparung gebildet ist, die Aussparung ist damit zwischen der herausragenden Kontaktfläche und einem äußerem Randbereich des Befestigungsbereiches angeordnet, der äußere Randbereich ist als ein umlaufender Kragen um die Aussparung ausgestaltet wobei der Kragen tiefer angeordnet ist als die herausragende Kontaktfläche und eine zur Montagefläche gerichtete Kragenfläche aufweist, ein ringförmiges Dichtelement aufweisend eine Dichtlippe, eine erste Auflagefläche und eine zweite Auflagefläche, ist derart ausgestaltet, dass die Dichtlippe in der Aussparung, die erste Auflagefläche auf der Kragenfläche und die zweite Auflagefläche zur Montagefläche angeordnet ist, wobei das Dichtelement die herausragende Kontaktfläche ringförmig umschließt.

Durch diese konstruktiven Maßnahmen werden Anhaftungen von Verunreinigungen und daraus folgende Kontaminationen der Automatisierungskomponente vermieden. Eine besondere Ausgestaltung sieht vor, dass das Dichtelement bündig mit der Außenfläche des Fußes abschließt und dass das Dichtelement an dieser Stelle in seiner Dicke etwas größer als die herausragende Kontaktfläche ausgelegt ist, so dass im montierten Zustand zwischen Kragenfläche und Montagefläche das Dichtelement derart komprimiert angeordnet ist, dass sich dazwischen ein spaltfreier Übergang ausbildet. Die Dicke ist etwas größer als der Abstand zwischen den zwei Flächen, welcher dem Maß des Herausragens der Kontaktfläche über den Kragen entspricht.

Die Erfindung bietet die Möglichkeit einer kostengünstigen hygienischen Abdichtung von Befestigungsbereichen bzw. Anschraubbereichen. Im Nahrungs- und Genussmittelbereich werden die für diese Erfindung notwendigen zusätzlichen Anschaffungskosten akzeptiert, da die dauerhaft notwendigen und höheren Reinigungskosten, bei nicht hygienegerecht ausgeführten Komponenten, die einmaligen Anschaffungskosten um ein Vielfaches übersteigen.

Durch die Füße ist eine ausreichend gute Zugänglichkeit aller Oberflächen der Automatisierungsbaugruppe für die Reinigung, auch mit Niedrigdruck-Wasser und mittels Putzlappen mit der Hand möglich.

Dementsprechend ist das Gehäuse und damit das Oberteil und das Unterteil als eine sich längsersteckende Umhausung zwischen dem ersten Fuß und dem zweiten Fuß ausgestaltet ist, wobei die Füße zumindest eine Länge aufweisen, dass die Oberfläche des Unterteils so zur Montagefläche beabstandet ist, dass eine menschliche Hand mit einem Putzmittel hindurch gleiten kann.

Damit Flüssigkeiten von der Automatisierungskomponente gut und rasch abfließen können ist das Gehäuse und damit das Oberteil und das Unterteil derart ausgestaltet, das sich in einer Vorzugseinbaulage, bei welcher die Befestigungsöffnungen senkrecht übereinanderstehen, das Gehäuse ausgehend von der ersten Befestigungsöffnung sich in Richtung der zweiten Befestigungsöffnung verjüngt.

Vorteilhafter ist das Gehäuse derart ausgestaltet, dass Flächen derart geformt sind, dass eine Ablagerung von Verunreinigungen vermieden oder minimiert wird. Also keine scharfen Kanten oder Vertiefungen.

Die Zeichnung zeigt ein Ausführungsbeispiel der Erfindung, dabei zeigt
- FIG 1: eine Automatisierungskomponente als ein dezentrales I/O-Gerät,
- FIG 2: die Automatisierungskomponente in einer dreidimensionalen Ansicht auf eine Hinterseite,
- FIG 3: die Automatisierungskomponente in einer Sicht auf eine Vorderseite,
- FIG 4: die Automatisierungskomponente mit einer Sicht auf eine Unterseite,
- FIG 5: eine Detaildarstellung eines Fußes der Automatisierungskomponente,
- FIG 6: ein Dichtelement,
- FIG 7: wiederum eine Detaildarstellung eines Fußes und
- FIG 8: eine weitere Detaildarstellung eines Fußes.

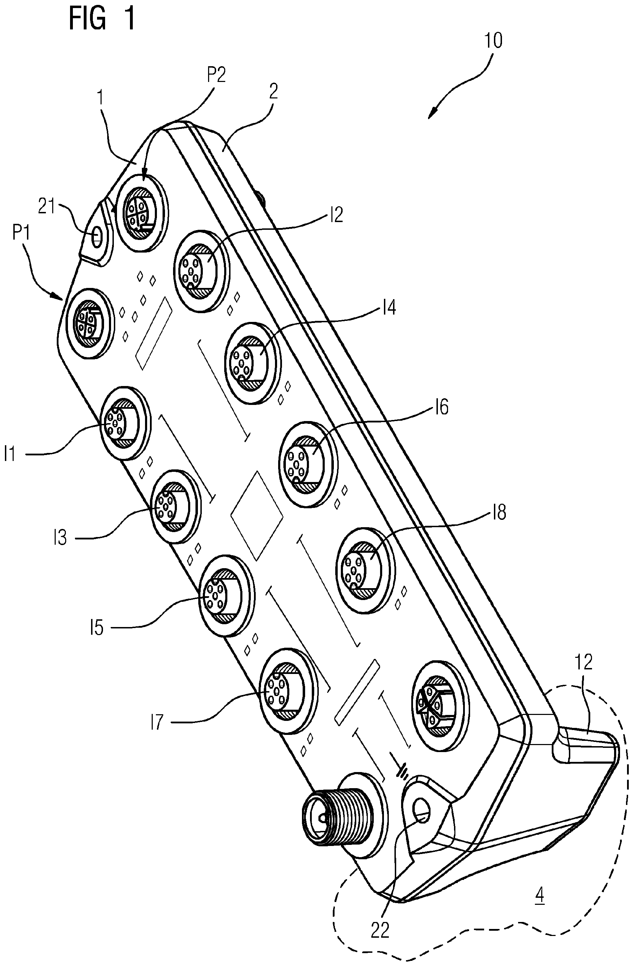

Gemäß FIG 1 ist eine Automatisierungskomponente 10 für die industrielle Automatisierung dargestellt. Die Automatisierungskomponente 10 ist ausgestaltet, als ein I/O-Peripheriemodul. Die Automatisierungskomponente 10 weist ein Gehäuse 3 umfassend ein Oberteil 1 und ein Unterteil 2 auf, wobei das Oberteil 1 und das Unterteil 2 derart ausgestaltet sind, dass zum Befestigen der Automatisierungskomponente 10 an einer Montagefläche 4 das Gehäuses 3 eine erste Befestigungsöffnung 21 und eine zweite Befestigungsöffnung 22 aufweist.

Die Automatisierungskomponente 10 weist für eine Kommunikation zu Sensoren oder Aktoren beispielsweise mit dem I/O-Link Protokoll einen ersten bis achten I/O-Anschluss I1,...,I8 auf. Damit die Automatisierungskomponente 10 Signale von einer übergeordneten Steuerung empfangen kann, weist sie einen ersten Profinet-Anschluss P1 auf. Ein weiterer zweiter Profinet-Anschluss P2 dient dazu, weitere Automatisierungskomponenten mit dem Profinet zu verbinden.

Das Unterteil 2 weist einen ersten Fuß 11 und einen zweiten Fuß 12 auf, wobei die Füße 11,12 einstückig mit dem Unterteil 2 ausgebildet sind.

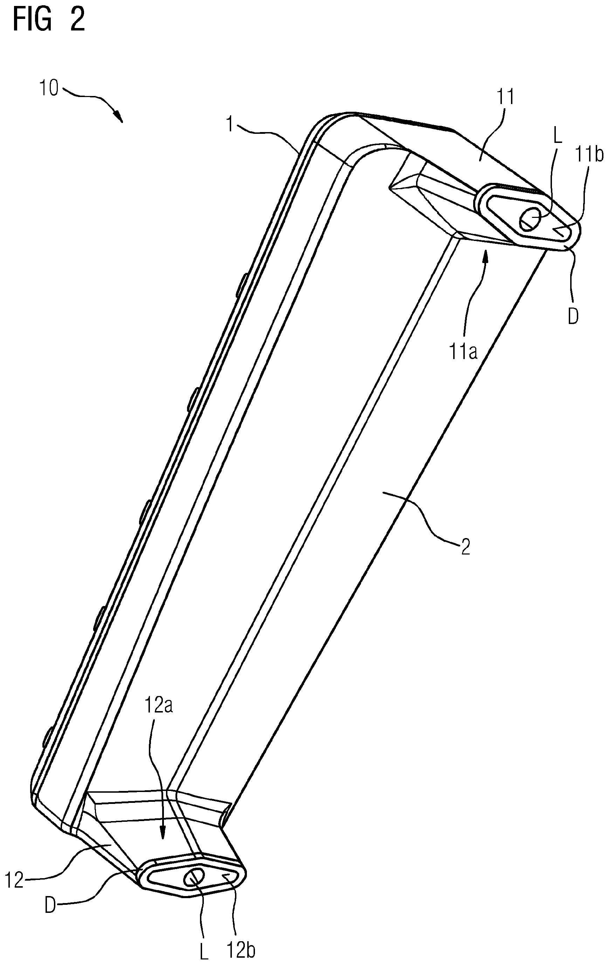

Mit der FIG 2 wird die einstückige Ausbildung des ersten Fußes 11 und des zweiten Fußes 12 verdeutlicht. Die erste Befestigungsöffnung 21 verläuft durch den ersten Fuß 11 und die zweite Befestigungsöffnung 22 verläuft durch den zweiten Fuß 12. Der erste Fuß 11 und der zweite Fuß 12 weisen zum Befestigen auf der Montagefläche 4 ein Befestigungsbereich 11a bzw. 12a auf. Für eine Befestigung auf der Montagefläche 4 ist eine Kontaktfläche 11b bzw. 12b innerhalb des Befestigungsbereiches 11a,12a angeordnet. Ein Loch L der ersten Befestigungsöffnung 21 ist wiederum innerhalb der ersten Kontaktfläche 11b angeordnet. Auch ist ein Loch L in der zweiten Befestigungsöffnung 22 wiederum in der zweiten Kontaktfläche 12b angeordnet.

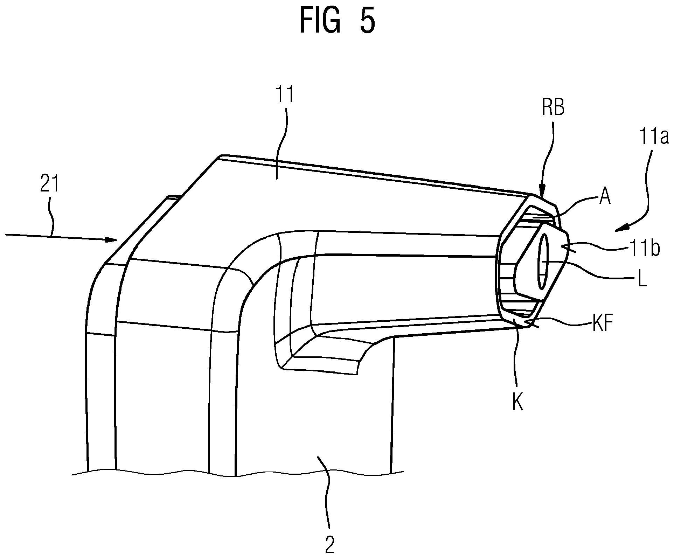

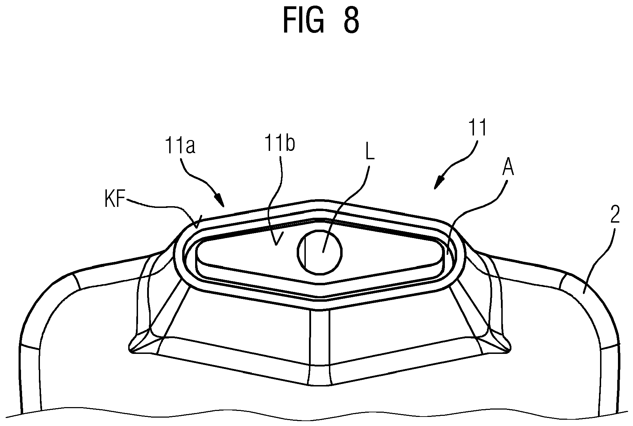

Die Kontaktflächen 11b,12b sind derart ausgestaltet, dass sie aus dem jeweiligen Befestigungsbereich 11a,12a herausragen und dadurch eine die Kontaktfläche 11b,12b ringförmig umschließende Aussparung A gebildet ist (dies wird besonders verdeutlicht mit FIG 5 und FIG 8).

In dem ersten Fuß 11 und dem zweiten Fuß 12 ist jeweils ein Dichtelement D eingesetzt. Das Dichtelement D schließt bündig mit der Außenfläche des ersten Fußes 11 ab, wobei das Dichtelement an dieser Stelle in seiner Dicke etwas größer ist als die herausragende Kontaktfläche, um so in einem montierten Zustand zwischen einer Kragenfläche KF und der Montagefläche 4 das Dichtelement D komprimiert anzuordnen, so dass sich dazwischen ein spaltfreier Übergang ausbildet.

Die FIG 5 zeigt in einer Ausschnittdarstellung ein Detail des ersten Fußes 11. Der erste Fuß 11 weist zum Befestigen auf der Montagefläche 4 einen Befestigungsbereich 11a auf, dazu ist eine Kontaktfläche 11b innerhalb des Befestigungsbereiches 11a angeordnet, wobei ein Loch L der Befestigungsöffnung 21 wiederum innerhalb der Kontaktfläche 11b angeordnet ist.

Die Kontaktfläche 11b ist derart ausgestaltet, dass sie aus dem Befestigungsbereich 11a herausragt und dadurch eine die Kontaktfläche 11b ringförmig umschließende Aussparung A gebildet ist. Die Aussparung A ist damit zwischen der herausragenden Kontaktfläche 11b und einem äußeren Randbereich RB des Befestigungsbereiches 11a angeordnet. Der äußere Randbereich RB ist als ein umlaufender Kragen K um die Aussparung A ausgestaltet, wobei der Kragen K tiefer angeordnet ist, als die herausragende Kontaktfläche 11b und eine zur Montagefläche 4 gerichtete Kragenfläche KF aufweist.

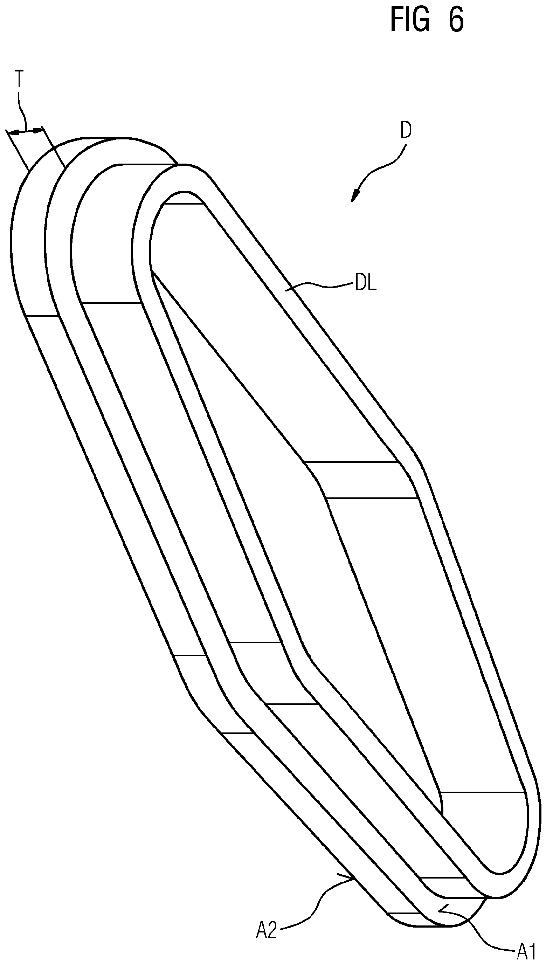

Mit der FIG 6 wird das ringförmige Dichtelement D gezeigt. Das Dichtelement D weist eine Dichtlippe DL, eine erste Auflagefläche A1 und eine zweite Auflagefläche A2 auf. Das Dichtelement D ist derart ausgestaltet, dass die Dichtlippe DL als eine Art Montagelippe in der Aussparung A, die erste Auflagefläche A1 auf der Kragenfläche KF und die zweite Auflagefläche A2 zur Montagefläche 4 angeordnet ist, dabei umschließt das Dichtelement D die herausragende Kontaktfläche 11b ringförmig.

Das Dichtelement D hat eine Dicke T, wobei die Dicke T etwas größer gewählt ist als der Abstand zwischen der Kragenfläche KF und der Montagefläche 4, so dass im montierten Zustand zwischen der Kragenfläche KF und der Montagefläche 4 das Dichtelement D derart komprimiert angeordnet ist, dass sich dazwischen ein spaltfreier Übergang ausbildet.

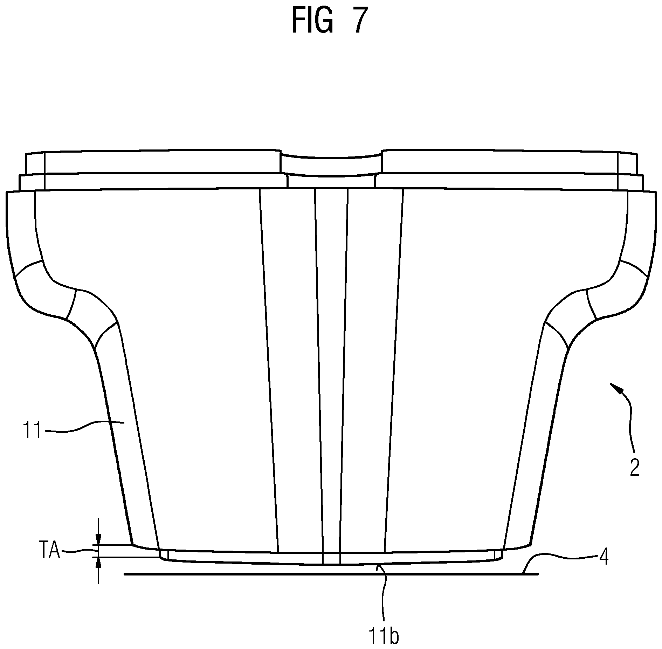

Die FIG 7 verdeutlicht noch einmal das Verhältnis zwischen der Dicke T des Dichtelementes D und dem Abstand TA zur Montagefläche 4.

Die FIG 8 zeigt noch einmal eine andere perspektivische Darstellung auf den ersten Fuß 11.

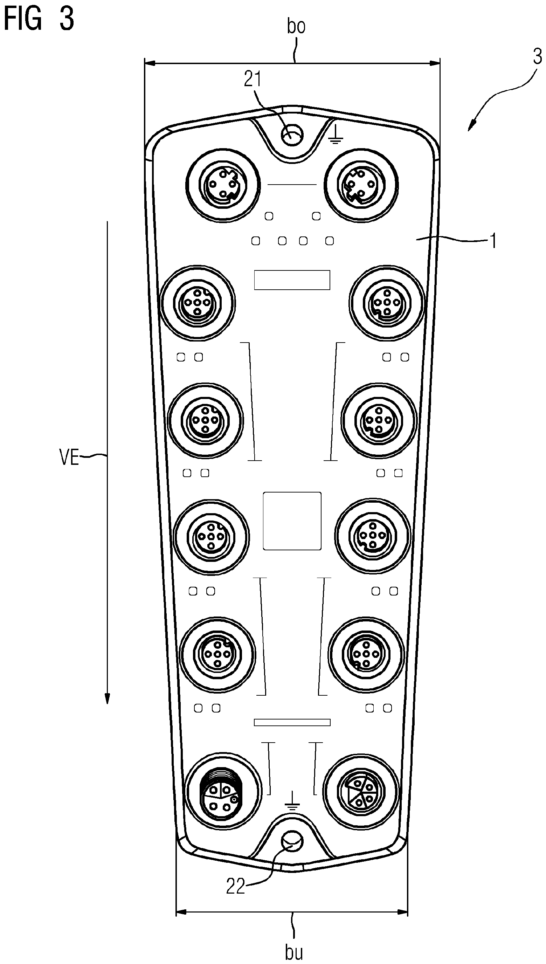

Gemäß FIG 3 ist das Gehäuse 3 und damit das Oberteil 1 und das Unterteil 2 derart ausgestaltet, dass sich in einer Vorzugseinbaulage VE die erste Befestigungsöffnung 21 oben befindet und die zweite Befestigungsöffnung 22 sich unten befindet. Die Befestigungsöffnung 21,22 stehen senkrecht übereinander. Das Gehäuse 3 ist ausgehend von der Befestigungsöffnung 21 in Richtung der zweiten Befestigungsöffnung 22 verjüngt ausgebildet. Eine Breite oben bo ist größer gewählt als eine Breite unten bu. Dementsprechend ist die Automatisierungskomponente 10 an der ersten Befestigungsöffnung 21 breiter ausgelegt als an der zweiten Befestigungsöffnung 22. Dies hat zur Folge, dass Flüssigkeiten von der Automatisierungskomponente 10 gut und rasch ablaufen können.

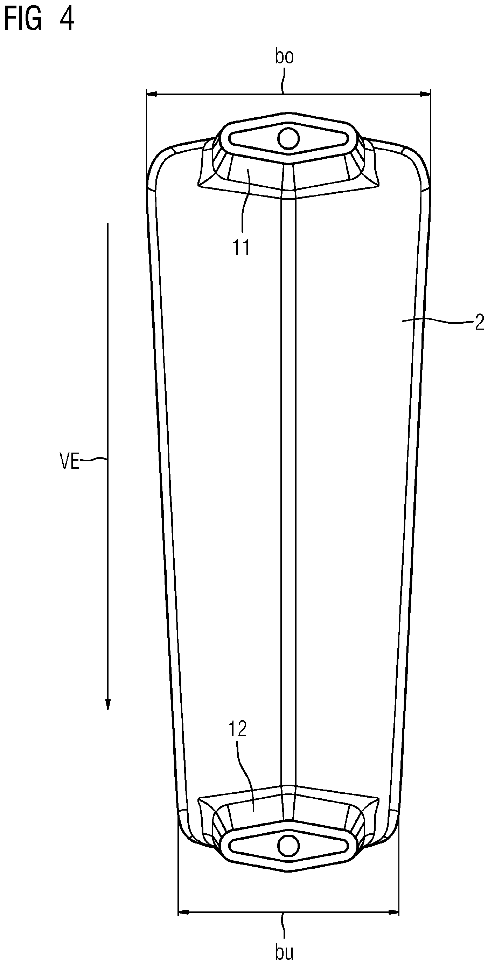

Wie FIG 4 und insbesondere die FIG 2 zeigen, ist durch die Ausführung der Füße 11,12 eine ausreichend gute Zugänglichkeit aller Oberflächen der Automatisierungsbaugruppe 10 für die Reinigung, auch mittels Niedrigdruck-Wasser und mittels Putzlappen mit der Hand möglich. Das bedeutet, dass sich die längserstreckende Umhausung zwischen dem ersten Fuß 11 und dem zweiten Fuß 12 derart ausgebildet ist, dass die Oberfläche des Unterteils 2 so zur Montagefläche 4 beabstandet ist, dass eine menschliche Hand mit einem Putzmittel hindurchgleiten kann.

Durchgehend weist das Gehäuse 3 eine derartige Ausgestaltung auf, dass alle Flächen und Übergänge und Rundungen derart geformt sind, dass eine Ablagerung von Verunreinigungen vermieden oder minimiert wird.

## Patentansprüche

1. Automatisierungskomponente (10) für die industrielle Automatisierung aufweisend ein Gehäuse (3) umfassend ein Oberteil (1) und ein Unterteil (2), wobei das Oberteil (1) und das Unterteil (2) derart ausgestaltet sind, dass zum Befestigen der Automatisierungskomponente (10) an einer Montagefläche (4) das Gehäuse (3) eine erste Befestigungsöffnung (21) und eine zweite Befestigungsöffnung (22) aufweist,
**dadurch gekennzeichnet, dass** das Unterteil (2) einen ersten Fuß (11) und einen zweiten Fuß (12) aufweist, wobei die Füße (11,12) einstückig mit dem Unterteil (2) ausgebildet sind und die erste Befestigungsöffnung (21) durch den ersten Fuß (11) und die zweite Befestigungsöffnung (22) durch den zweiten Fuß (12) verläuft, die Füße (11,12) weisen zum Befestigen auf der Montagefläche (4) einen Befestigungsbereich (11a,12a) auf, dazu ist eine Kontaktfläche (11b,12b) innerhalb des Befestigungsbereiches (11a,12a) angeordnet, wobei ein Loch (L) der Befestigungsöffnung (21) wiederum innerhalb der Kontaktfläche (11b,12b) angeordnet ist, die Kontaktfläche (11b,12b) ist derart ausgestaltet, dass sie aus dem Befestigungsbereich (11a, 12a) herausragt und dadurch eine die Kontaktfläche (11b,12b) ringförmig umschließende Aussparung (A) gebildet ist, die Aussparung (A) ist damit zwischen der herausragenden Kontaktfläche (11b,12b) und einem äußerem Randbereich (RB) des Befestigungsbereiches (11a,12a) angeordnet, der äußere Randbereich (RB) ist als ein umlaufender Kragen (K) um die Aussparung (A) ausgestaltet, wobei der Kragen (K) tiefer angeordnet ist als die herausragende Kontaktfläche (11b) und eine zur Montagefläche (4) gerichtete Kragenfläche (KF) aufweist, ein ringförmiges Dichtelement (D) aufweisend eine Dichtlippe (DL), eine erste Auflagefläche (A1) und eine zweite Auflagefläche (A2), ist derart ausgestaltet, dass die Dichtlippe (DL) in der Aussparung (A), die erste Auflagefläche (A1) auf der Kragenfläche (KF) und die zweite Auflagefläche (A2) zur Montagefläche (4) angeordnet ist, wobei das Dichtelement (D) die herausragende Kontaktfläche (11b) ringförmig umschließt.

2. Automatisierungskomponente (10) nach Anspruch 1, wobei das Gehäuse (3) und damit das Oberteil (1) und das Unterteil (2) als eine sich längsersteckende Umhausung zwischen dem ersten Fuß (11) und dem zweiten Fuß (12) ausgestaltet ist, wobei die Füße (11,12) zumindest eine Länge aufweisen, dass die Oberfläche des Unterteils (2) so zur Montagefläche (4) beabstandet ist, dass eine menschliche Hand mit einem Putzmittel hindurch gleiten kann.

3. Automatisierungskomponente (10) nach Anspruch 1 oder 2, wobei das Gehäuse (3) und damit das Oberteil (1) und das Unterteil (2) derart ausgestaltet sind, dass sich in einer Vorzugseinbaulage (VE), bei welcher die Befestigungsöffnungen (21,22) senkrecht übereinanderstehen, das Gehäuse (3) ausgehend von der ersten Befestigungsöffnung (21) sich in Richtung der zweiten Befestigungsöffnung (22) verjüngt.

4. Automatisierungskomponente (10), nach einem der Ansprüche 1 bis 3, wobei das Gehäuse (3) derart ausgestaltet ist, dass Flächen derart geformt sind, dass eine Ablagerung von Verunreinigungen vermieden oder minimiert wird.
